# EUROPEAN PATENT APPLICATION

(11) **EP 4 822 379 A1**
(43) Date of publication of application: **14.10.2026**
(21) Application number: 25169010.3
(22) Date of filing: 08.04.2025
(51) Int. Cl.: G01R 33/34

(54) **A COIL ARRANGEMENT (100) FOR USE IN AN MRI SYSTEM AND MRI SYSTEM**

(71) Applicant: Koninklijke Philips N.V., 5656 AE Eindhoven (NL)
(72) Inventor: LEUSSLER, Christoph Günther, Eindhoven (NL)
(74) Representative: Philips Intellectual Property & Standards

(57) **Abstract**

Proposed concepts aim to provide schemes, solutions, concepts, designs, methods, and systems pertaining to a coil arrangement for use in an MRI system. In particular, embodiments provide a coil arrangement including two different coil arrays (110, 121, 122). An actuator (130) and controller (140) are used together to automatically move the second coil array (121, 122) relative to the first coil array (110) between an undeployed position (Figure 1A), which permits patient positioning, and a deployed position (Figure 1B), which is suitable for imaging using both coil arrays.

## Description

### FIELD OF INVENTION

The present invention pertains to the field of magnetic resonance imaging systems, and more particularly to coil arrangements for use in magnetic resonance imaging systems.

### BACKGROUND OF THE INVENTION

Magnetic resonance imaging (MRI) is a medical imaging technique used in radiology to form pictures of the anatomy and the physiological processes of the body. MRI is used widely in hospitals and clinics for medical diagnosis. MRI scanners use strong magnetic fields generated by superconducting magnets, magnetic field gradients, and radio waves to generate images of the organs of the body. MRI is based on the ability of certain atomic nuclei to absorb radio frequency energy when placed in an external magnetic field. The resulting evolving spin polarisation can induce an RF signal in a radio frequency coil and thereby be detected.

Coil arrangements are therefore used in MRI systems for both transmitting and receiving radio frequency signals from a patient being imaged. Separate coils may be used for transmitting and for receiving, or alternatively a single coil may be used for both functions.

In the MRI clinical workflow, it is beneficial if the clinician operating the MRI system can focus less on the technology of the MRI scanner and instead fully engage with the patient. This can improve the patient experience and diagnosis. Reducing and simplifying the number of steps needed for patient preparation before an MRI scan can help to achieve this. Reducing MRI clinical workflow may also provide time saving and improve the value of MRI systems by increasing the availability of MRI for patients and decreasing the time that patients spend in the MRI department. Recently developed methods for reducing MRI workflow include the use of dockable tables, dedicated MRI preparation rooms, and duplication of commonly used coils.

One aspect of patient preparation that takes up a considerable amount of time is the positioning and placement of the coil arrays for accurate imaging. Often patient coils are required to completely surround the features of the patient being imaged. This means that the patient requires assistance in being positioned within the coil arrangement and cannot escape from the coil in the event of an emergency or panic. Valuable clinician time and focus is therefore spent in helping the patient to be positioned within the coil and ensuring they are comfortable.

### SUMMARY OF INVENTION

The invention is defined by the claims.

According to examples in accordance with an aspect of the invention, there is provided a coil arrangement for use in an MRI system. The coil arrangement comprises: first and second coil arrays each configured, in use, to transmit signals to and/or receive signals from an anatomical feature of a subject that is to be imaged by the MRI system, wherein the second coil array is configured to be moveable relative to the first coil array between an undeployed position, in which the second coil array permits the anatomical feature of the subject to be positioned relative to the first coil array such that MRI of the anatomical feature can be performed using the first coil array, and a deployed position, in which the second coil array is positioned such that MRI of the anatomical feature can be performed using both the first and second coil arrays; an actuator arrangement configured to move the second coil array between the undeployed position and the deployed position; and a controller for controlling the actuator arrangement.

Proposed concepts thus aim to provide schemes, solutions, concepts, designs, methods, and systems pertaining to a coil arrangement for use in an MRI system. In particular, embodiments provide a coil arrangement including two different coil arrays. An actuator and controller are used together to automatically move the second coil array relative to the first coil array between an undeployed position, which permits patient positioning, and a deployed position, which is suitable for imaging using both coil arrays.

Coil arrangements in modern MRI systems often utilise volume coil array systems which completely encompass an anatomical feature being imaged in a particular plane. This can help to improve the sensitivity and resolution of the imaging. However, these systems have the drawback that it can be difficult for a patient to be positioned within the relatively small volume of the volume coil array. It therefore requires a skilled operator to position the patient and then place the coil array in the correct position for accurate imaging.

Making MRI workflow more efficient is a key concern in modern MRI systems. In conventional systems, the patient has to be carefully placed within a coil array by an operator, and the coil array then correctly positioned relative to the patient for accurate imaging. This uses up valuable operator time and means that the patient is trapped in the coil and cannot abandon the coil in the case of panic or a safety issue.

The coil arrangement of the present invention has an integrated second deployable coil array propelled by an actuator which is controlled by a controller. When the second coil array is in an undeployed position, the subject can easily position themselves with respect to the stationary first coil array. Once the subject is in position, the actuator arrangement can then be controlled to deploy the second coil array to a deployed position which allows for accurate imaging of the subject using both the first and second coil arrays.

The proposed coil arrangement is advantageous in that it allows the patient to position themselves with respect to the coil array with little to no guidance from the operator of the MRI system. Once in position, the actuator is configured to deploy the second coil array to a position in which accurate imaging can take place. Therefore, in systems leveraging the proposed invention, the operator neither needs to take time to position the subject relative to the imaging system nor take time to place the coil arrays once the subject is in position. Patient experience and comfort may therefore be improved.

Ultimately, an improved coil arrangement for an MRI system may be provided by the proposed concept(s).

In some embodiments, when the coil array is in the deployed position, the first and second coil arrays may, in use, extend around the anatomical feature of the subject about a longitudinal axis, and optionally when the second coil array is in the deployed position, in use, the first and second coil arrays may fully encompass the anatomical feature of the subject in a first plane perpendicular to the longitudinal axis. This configuration ensures the coil provides the system with a large field of view and improved imaging resolution.

In some embodiments, the second coil array may comprise a plurality of shutter elements, each of the plurality of shutter elements coupled to an adjacent shutter element of the plurality of shutter elements by a hinge mechanism. This provides a robust but flexible mechanism in which the shape and position of the second coil array can be adjusted.

In some embodiments, the second coil array may comprise a first portion and a second portion and movement of the second coil array from the undeployed position to the deployed position may comprise movement of the first portion in a first direction and movement of the second portion in a second direction different from the first direction. The existence of first and second portions may reduce the distance with which elements of the second coil array are required to move between the deployed and the undeployed position. This embodiment may therefore improve the stability of the coil arrangement in the deployed position.

In some embodiments, the coil arrangement may further comprise a biasing system configured to bias the second coil array to the undeployed position. This may ensure that in an emergency or a power outage, the second coil array reverts to the undeployed position, allowing the subject to remove themselves from the coil arrangement safely.

In some embodiments, the second coil array may comprise a flexible arrangement such that the shape of the second coil array can be adjusted when the second coil array moves between the deployed position and the undeployed position. This configuration may provide greater flexibility as to how the second coil array is stored when undeployed to allow the coil arrangement to be compact.

In some embodiments, the controller may be configured to: receive an instruction signal; and control the actuator arrangement to move the second coil array between the undeployed position and the deployed position based on the received instruction signal. Thus, proposed embodiments allow for automatic deployment of the second coil array in response to a received instruction signal.

In some embodiments, the controller may be configured to receive a system status signal describing the status of the MRI system; and control the actuator arrangement to move the second coil array between the undeployed position and the deployed position based on the received system status signal. The status of the MRI system can therefore inform automatic movement of the second coil array - removing the requirement of operator input for timing the deployment of the second coil array. This reduces the operator's workflow even further.

In some embodiments, the status signal may describe at least one of: a loading state which indicates the subject or an imaging phantom is being positioned relative to the coil arrangement; a travel state which indicates the coil arrangement is being transported; an imaging state which indicates the coil arrangement is in use for imaging the anatomical feature of the subject; a therapy state which indicates a clinical therapy is being applied to the subject; a preparation state which indicates a contrast agent is being applied to the subject; and an emergency state. In each of these states it may be preferable for the second coil to be in either the deployed or the undeployed position and therefore the automatic movement of the second coil to the preferred position in response to a signal describing any of these states may improve the efficiency of the MRI procedure.

In some embodiments, the controller may be configured to: receive a subject status signal describing a state of the subject; and control the actuator arrangement to move the second coil array between the deployed and the undeployed positions based on the received subject status signal. The coil arrangement can therefore be advantageously configured to automatically change its state in response to the state of the subject.

In some embodiments, the subject status signal may describe at least one of: a panic level of the subject; a motion level of the subject; a position of the subject; a level of discomfort of the subject; and a vital sign measurement of the subject. Each of these signals may help to inform when the subject is in an emergency state, or in distress, wherein it is beneficial for the second coil array to be in the undeployed position such that the patient can easily be removed from the MRI system.

In some embodiments, the controller may be configured to: receive a sensor signal describing a measurement of a sensor of the MRI system; and control the actuator arrangement to move the second coil array between the deployed and the undeployed positions based on the received sensor signal. The use of sensors in this way can be used to automatically trigger the actuator arrangement to move the second coil array in response to a measured change in the environment of the MRI system. This may for example be used to automatically release the subject from the coil array in the event of an emergency scenario such as a fire or overheating of the system. Alternatively, or in addition the sensor signal may indicate the level of interaction of the second coil array with other electromagnetic elements of the MRI system and the position of the second coil array can be adjusted in response to a sensor signal to improve the signal-to-nose ratio.

In some embodiments, the sensor signal may describe at least one of: a position of the subject; a presence of smoke; a temperature; a motion of the subject; a detected sound; and a vital sign of the subject. The sensor signal can therefore be used to accurately ascertain if there are any safety concerns that require the second coil array to be in the undeployed position such that the subject can be removed from the system.

According to another aspect of the invention, there is provided an MRI system for imaging an anatomical feature of a subject, the MRI system comprising: a patient support structure for supporting the position of the anatomical feature for imaging by the MRI system; a superconducting magnet; a gradient coil; and any of the coil arrangements described above. Thus, the concepts of the proposed invention may advantageously be integrated into conventional MRI systems.

In some embodiments, the MRI system may further comprise one or more sensors for measuring at least one of: the state of the MRI system; and the state of the subject. These sensors can then be used to automatically trigger the second coil array to move between the undeployed and the deployed position. The use of such sensors therefore permits the second coil array to be activated at suitable moments, reducing the requirement for a clinician to actively control the positioning of the coil arrangement.

Embodiments may be employed in combination with conventional/existing MRI systems. In this way, embodiments may integrate into legacy systems to improve and/or extend their functionality and capabilities. An improved MRI system including a coil arrangement that allows for automatic deployment of a coil array may therefore be provided by proposed embodiments.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Figs. 1A and 1B are a simplified diagrams of a coil arrangement for an MRI system according to a proposed embodiment;
Figs. 2A and 2B are simplified diagrams of a coil arrangement for an MRI system according to another proposed embodiment;
Fig. 3 is a diagram of an example configuration of a plurality of shutter elements of the second coil array;
Figs. 4A, 4B, and 4C are simplified diagrams of a coil arrangement for an MRI system according to a third proposed embodiment;
Fig. 5 is a simplified flow diagram of an algorithm for controlling a coil arrangement of the present invention; and
Fig. 6 is a simplified diagram of an MRI system according to another aspect of the proposed invention.

### DETAILED DESCRIPTION OF THE EMBODIMENTS

The invention will be described with reference to the Figures.

It should be understood that the detailed description and specific examples, while indicating exemplary embodiments of the apparatus, systems, and methods, are intended for the purpose of illustration only and are not intended to limit the scope of the invention. These and other features, aspects, and advantages of the apparatus, systems, and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

Implementations in accordance with the present disclosure relate to various techniques, methods, schemes, and/or solutions pertaining to coil arrangements for use in MRI systems. According to proposed concepts, a number of possible solutions may be implemented separately or jointly. That is, although these possible solutions may be described below separately, two or more of these possible solutions may be implemented in one combination or another.

In conventional volume coil arrays, a skilled operator needs to expend significant time and care positioning the subject relative to the coil array. The coil arrangement of the present invention is advantageous as it allows a subject to position themselves for imaging, and for the coil to be positioned for imaging, without the assistance of an operator. This can provide significant time saving for the operator, improving workflow efficiency. This result is achieved by a deployable second coil array that can be arranged in either of two positions. In the first (undeployed position) the second coil array is stored within the coil arrangement such that subject can position themselves uninhibited with respect to the first coil array. Actuation of the second coil array by a controlled actuator results in the automatic movement of the second coil array to a second (deployed position) in which accurate imaging can be achieved. As such, there is no need for the operator to manually manipulate the coil arrays into position.

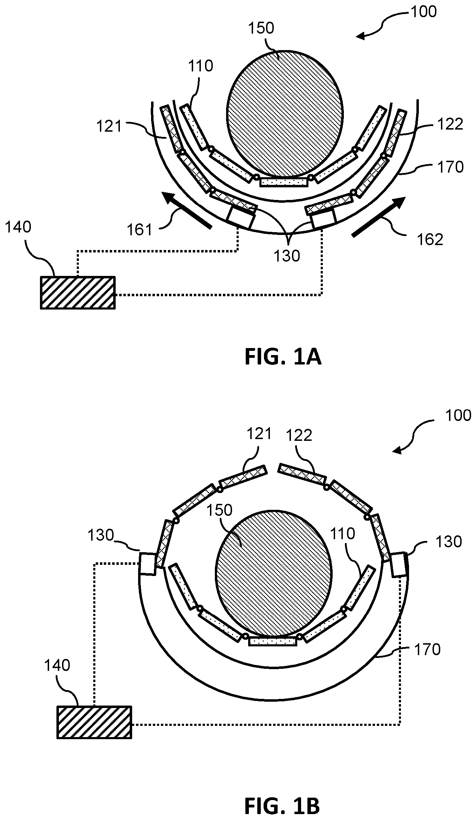

Referring now to Figs. 1A and 1B, there is depicted a simplified diagram of a coil arrangement 100 for an MRI system according to a proposed embodiment.

The coil arrangement 100 comprises a first coil array 110 and a second coil array 120 configured, in use, to transmit signals to and receive signals from an anatomical feature 150 of a subject that is to be imaged by the MRI system, which in this example is the head and neck of the subject. In this exemplary embodiment, the first and second coil arrays are combined transmitting and receiving coil arrays; however, in other embodiments the first and second coil arrays may perform only one of these functions. The first and second coil arrays of the coil arrangement 100 are configured for radio frequency signal transmission and receival, but the present invention is not limited to only these frequencies.

In this exemplary embodiment, the first and second coil arrays each comprise a plurality of shutter elements, each of the plurality of shutter elements coupled to an adjacent shutter element of the plurality of shutter elements by a hinge mechanism. Further, in this embodiment, the plurality of shutter elements of the second coil array 120 are split into two portions, such that the second coil array 120 comprises a first portion 121 and a second portion 122.

In this example, each shutter element of the first and second coil arrays is a rigid element containing one coil or part of a coil. The individual coil elements of adjacent shutter elements are electrically connected to one another via flex PCBs (printed circuit boards) or flexible conductors. Thus, in use, the coil elements of the individual shutter elements work cooperatively as a whole to generate and receive radio frequency signals during imaging.

The coil arrangement 100 further comprises an actuator arrangement 130 configured to move the second coil array 120 between an undeployed position, shown in Fig. 1A, and a deployed position, as shown in Fig. 1B, under the control of a controller 140. In this exemplary embodiment, the coil arrangement 100 further comprises a guidance channel 170 configured to guide the movement of the second coil array between the undeployed and the deployed position.

It will be understood by a person skilled in the field that the actuator arrangement 130 and the controller 140 can be implemented in various ways. For example, the actuator may be a pneumatic actuator or an electromechanical actuator. The actuator arrangement may comprise several different actuator elements, as shown in Figs. 1A and 1B, or may comprise a single actuator. The specific configuration of the actuator arrangement 130 can be adjusted depending on the geometry and configuration of the first and second coil arrays.

The controller 140 is configured to dictate at what point in time the actuator arrangement 130 drives movement of the second coil array 120. In this exemplary embodiment, the controller simply comprises a switch which may be operated by an operator of the MRI system to active and deactivate the actuator arrangement. In this example the controller is external to first and second coil arrays, to allow the operator to control the actuator from a distance. The operator may therefore interact with the controller 140 to control the second coil array 120 to move between the deployed and the undeployed position at different stages of the imaging procedure. For example, the operator may interact with the controller 140 to control the actuator 130 to move the coil from the undeployed position to the deployed position when an MRI scan commences, and/or from the deployed position to the undeployed position at a particular point during the MRI procedure when the operator requires access to the surface of the subject's body. This may allow for the operator to perform interactive imaging therapy.

Fig. 1A shows the second coil 120 in an undeployed position in which the second coil array permits the anatomical feature 150 of the subject to be positioned relative to the first coil array 110 such that MRI of the anatomical feature can be performed using the first coil array. In this exemplary embodiment, in the undeployed position, the second coil array is stored underneath the first coil array such when the second coil array is in this position, the anatomical feature 150 of the subject can be freely positioned on top of the stationary first coil array which forms the base of the coil arrangement. Therefore, in this exemplary embodiment, when the second coil array is in the undeployed position, the coil arrangement has a wide opening in which the subject can position their anatomical feature relative to the fixed first coil array. The arrangement therefore allows the subject to position themselves with ease and without the assistance of a trained operator.

Fig. 1B shows the second coil array 120 in the deployed position, in which the second coil array 120 is positioned such that MRI of the anatomical feature can be performed using both the first and second coil arrays. Imaging sensitivity is improved if, during use, the coil arrangement wraps around the anatomical feature 150 in at least one plane. Therefore, in this exemplary embodiment, in the deployed position first and second coil arrays extend around the anatomical feature 150 about a longitudinal axis to fully encompass the anatomical feature in a plane perpendicular to the longitudinal axis.

In this exemplary embodiment, movement of the second coil array from the undeployed position to the deployed position comprises movement of the first portion 121 of the second coil array in a first direction (indicated in Fig. 1A by the arrow 161) and movement of the second portion 122 in a second direction (indicated in Fig. 1A by the arrow 162), wherein the second direction is different from the first direction. The exact position of the second coil array 120 in the deployed position may in some embodiments be adjusted depending on the type of anatomical feature to be imaged and its size and shape. As such, in some use cases the first and second portions of the second coil array may not fully encompass the anatomical feature of the subject but may only partially surround it to accommodate larger anatomical features.

Optionally, the coil arrangement 100 may further comprise a biasing system (not shown) configured to bias the second coil array 120 to the undeployed position. This may ensure that during a power outage or actuation failure, the second coil array 120 returns to the undeployed position such that it is easy for the subject to extradite themselves from the confines of the coil arrangement. Various means for implementing the biasing system will be understood by those working in the field. For example, the biasing system may comprise a spring.

Whilst in this example the coil arrangement 100 is configured for MRI of a subject's head and neck, the present invention is not limited to such. In alternative embodiments, the coil arrangement 100 may be used to image various anatomical features of the subject, for example the anatomical feature 150 may comprise at least one of: a head; a limb; a torso; an organ; and a neck of the subject.

Similarly, other features of the coil arrangement 100 may be implemented differently in alternative embodiments. For example, whilst in this embodiment the controller 140 simply comprises a switch, in other embodiments more complicated control systems may be used. For example, the controller 140 may be a component configured to receive an instruction signal and control the actuator arrangement to move the second coil array between the undeployed position and the deployed position based on the received instruction signal. The instruction signal received may describe various pieces of information that can be used to inform the activation of the actuator arrangement and respond to changes in the system. This might include responding to the stage of the imaging procedure, the state of the MRI system, and the state of the subject being imaged.

For example, the controller 140 may be configured to receive a system status signal describing the status of the MRI system and to control the actuator arrangement to move the second coil array between the undeployed position based on the received system status signal. The status of the MRI system the system status signal describes may be at least one of: a loading state which indicates the subject or an imagining phantom is being positioned relative to the MRI system; a travel state which indicates the MRI system is being transported; an imaging state which indicates the MRI system is in use for imaging the anatomical feature of the subject a therapy state which indicates a clinical therapy is being applied to the subject; a preparation state which indicates a contrast agent is being applied to the subject; and an emergency state. As such, a signal received by the controller may indicate that there is a state of emergency for example when there is a safety issue with the MRI system, when it is detected that a subject is unexpectedly present in the imaging system, or if there is a fire or break down of the MRI system.

Additionally, or alternatively, the controller 140 may be configured to receive a subject status signal describing a state of the subject and control the actuator arrangement based on the received subject status signal. The subject status signal may describe at least one of: a panic level of the subject; a discomfort level of the subject; a position of the subject; and a vital sign measurement of the subject. Thus, in some embodiments, if it is detected that the subject is in distress or uncomfortable, the controller may automatically control the actuator to move the second coil array to the undeployed position such that the subject can easily remove themselves from the situation. This may lead to an improved patient experience.

In some embodiments, the MRI system used in conjunction with the coil array of the present invention may include one or more sensors for detecting the environment around and within the MRI system. In this case, the controller may be configured to receive a sensor signal describing a measurement of a sensor of the MRI system and to control the actuator arrangement based on the received sensor signal. The sensor signal may describe at least one of: a position of the subject; a presence of smoke; a temperature; a motion of the subject and a vital sign of the subject. Thus, the controller may be configured receive instructions input by an operator and/or from sensors configured to detect and monitor the status of the MRI system and the subject.

The second coil array may interact via electromagnetic coupling with adjacent and remote electromagnetic elements (for example, additional coils) within the MRI system. In some embodiments, the sensor signal may therefore describe the interaction between the second coil array and other electromagnetic elements of the MRI system. The controller 140 in this embodiment is configured to control the movement of the second coil array between the undeployed position and the deployed position (for example, the position of the second coil array in the deployed position may be controller and/or adjusted) based on the sensor signal describing the interaction between the second coil array and other electromagnetic elements of the MRI system. In one possible implementation of such a system, the sensor signal comprises imaging data obtained by the MRI system in use. Upon receipt of the imaging data, the controller is configured to determine an SNR value (signal-to-noise ratio) associated with the imaging data and/or determine a level of imaging artifacts in the imaging data. Based on one or both of these values, the controller is configured to control the position of the second coil array in the deployed position. For example, the position of the second coil array in the deployed position may be adjusted until the SNR value of imaging data received at the controller satisfies a predetermined threshold value.

In the coil arrangement 100, the controller 140 is positioned externally to the first and second coil arrays. However, in other embodiments, all the components of the coil arrangement 100 may be integrated into the same structure.

Whilst in the configuration shown in Figs. 1A and 1B, the fixed first coil array 110 acts as a base and the moveable second coil array 120 acts as a top portion that, in the deployed position, extends above the first coil array to wrap around the anatomical feature of the subject, this need not be the case in all embodiments. For example, the first coil array may comprise a first side wall of the coil arrangement, and the second coil array may comprise an opposite side wall of the coil arrangement that, in the deployed position, is arranged opposite the first side wall. Similarly, whilst in the configuration described above the second coil array is stored underneath the first coil array in the undeployed position, the invention is not limited to this arrangement. For example, in another embodiment, in the undeployed position, the second coil array may be coiled or rolled such that it takes up a smaller volume when not in use. Therefore, the skilled person will understand that various different geometries and arrangements of the first and second coil array may be employed in the present invention so long as, in the undeployed position the second coil array permits the subject to be positioned for imaging, and in the deployed position accurate imaging of the subject can be achieved.

Similarly, whilst in the coil arrangement 100 the actuator arrangement 130 works in conjunction with the guidance channel 170 to guide the movement of the second coil array between the undeployed position and the deployed position, alternative structures and configurations of the actuator arrangement 130 and optional associated support structures are possible.

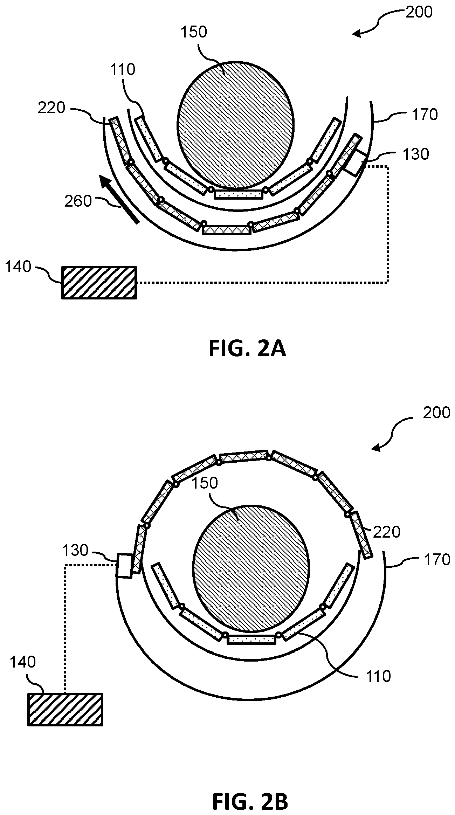

In the embodiment of Figs. 1A and 1B the second coil array 120 comprises first and second portions (121, 122) that are configured to move in different directions to encompass the anatomical feature of the subject when they are deployed. However, this need not be the case in other embodiments. For example, referring now to Figs. 2A and 2B, there is depicted a simplified diagram of a coil arrangement 200 for an MRI system according to another proposed embodiment.

The coil arrangement 200 differs from the coil arrangement 100 shown in Figs. 1A and 1B in that the second coil array comprises 220 a single portion that moves in a single direction 260 to move between the undeployed position shown in Fig. 1A to the deployed position shown in Fig. 1B. The first coil array 110, the actuator arrangement 130, the controller 140 of the coil arrangement 200 serve a similar function to the corresponding components of the coil arrangement 100 and so the description of these features will not be repeated.

In this arrangement, it may be easier to ensure that together the first and second coil arrays fully encompass the anatomical feature of the subject 150 to provide full imaging sensitivity. However, there is less flexibility in the position of the second coil array in the deployed position and therefore less ability to adapt the coil arrangement for imaging anatomical features of different shapes and sizes.

In each of the coil arrangement 100 and the coil arrangement 200, the first and second coil arrays each comprise a plurality of rigid shutter elements connected to one another via a hinge mechanism. In alternative embodiments, each of the shutter elements may themselves be flexible. For example, each of the shutter elements may comprise a flexible foam material.

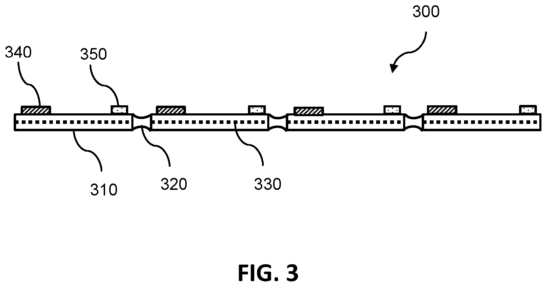

Referring now to Fig. 3, there is depicted a diagram of an example configuration of a plurality of shutter elements 321 of a second coil array 300, according to an embodiment of the invention. Fig. 3 shows only a portion of the second coil array 300. In certain embodiments the second coil array 300 may be the second coil array 120 of the coil arrangement 100 or the second coil array 220 of the coil arrangement 200.

The second coil array 300 comprises a plurality of shutter elements 310, each of the plurality of shutter elements 310 connected to an adjacent shutter element via a flexible hinge 320. The flexible hinges 320 permit adjacent shutter elements 310 to move with respect to each other to permit the shape of the second coil array 300 to change when it is moved from an undeployed position to a deployed position. In this example, the plurality of shutter elements 310 comprise a flexible material such that the shape of the second coil array 300 can also be adjusted as a result of the flex of each of the shutter elements 310. As an example, each shutter element 310 may have a thickness in the range of 3 to 5 mm.

Fixed on or within each shutter element 310 is a conductive element 330 which acts as a coil or part of a coil for transmitting and receiving signals from an anatomical feature of a subject. The conductive elements 330 may be affixed to the shutter element 310 via an adhesive and/or via electrochemical etching.

In this particular example, each shutter element 310 further comprises a sensor 340 and a marker element 350. Each sensor 340 is configured to sense the position of the marker 350 that resides on the same shutter element of the plurality of shutter elements 321. For example, the sensor 340 may be an image sensor or a LIDAR sensor.

In particular embodiments of the invention, when the second coil array 300 forms part of the coil arrangement 100 or the coil arrangement 200, the plurality of sensors 340 may be configured to generate a sensor signal which is transmitted to the controller 140, the sensor signal describing the relative position of each of the plurality of markers 350 to is corresponding sensor 340. The controller 140 is then be configured to use information about the relative position of the sensor 340 and the marker 350 of each shutter element 310 provided by each sensor 340 to determine information about the shape and position of each shutter element 310 of the second coil array 300. In this way, in this example, the controller 140 is configured to control the actuator arrangement 130 between the deployed position and the undeployed position based on the received sensor signal.

For example, in some embodiments, the actuator arrangement 130 may comprise a plurality of actuator elements which are each configured control the movement of a different portion of the second coil array. For example, each actuator element may be configured to move one or more shutter elements 310 of the second coil array 300. Based on the received sensor signal, the controller may be configured to independently control the movement of the different portions of the second coil array via the plurality of actuator elements to achieve the desired movement of the second coil array between the deployed position and the undeployed position based on the determined shape and position of the second coil array 300. This may allow for more accurate control of the second coil array between the deployed and the undeployed positions.

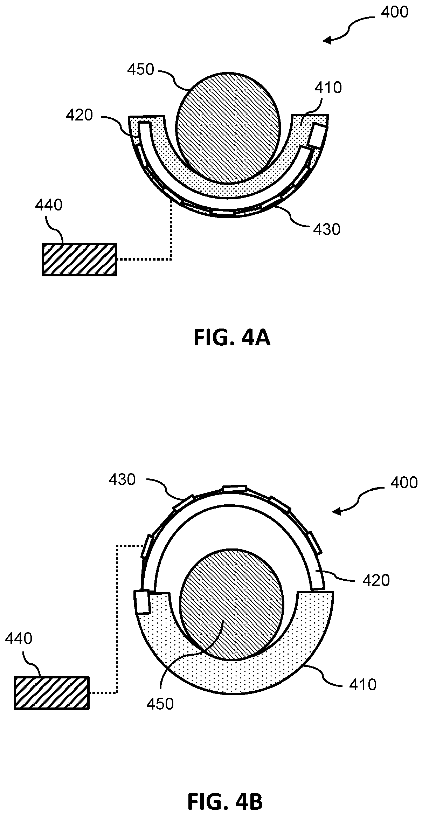

Referring now to Figs. 4A to 4C, there is depicted a simplified diagram of a coil arrangement 400 for an MRI system according to another proposed embodiment which implements an alternative design to the shutter element configuration shown in Figs. 1A-3B.

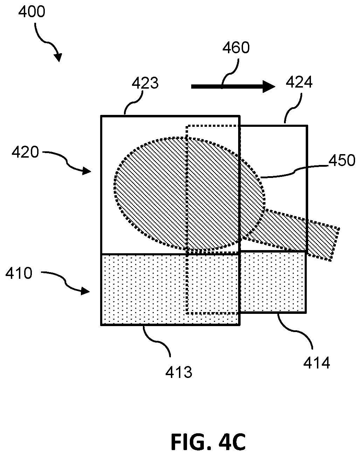

The coil arrangement 400 comprises a first coil array 410, a second coil array 420, an actuator arrangement 430, and a controller 440 for controlling the actuator arrangement 430 to move the second coil array between an undeployed position shown in Fig. 4A, and a deployed position, shown in Figs. 4B and 4C.

In the coil arrangement 400, the first coil array 410 comprises a solid base part suitable for supporting the anatomical feature of the subject 450 during imaging (which in this example is the subject's head and neck). The second coil array 420 comprises a continuous element comprising a flexible material such that the shape of the second coil array 420 can be adjusted when the second coil array moves between the deployed position and the undeployed position. Thus, the second coil array may be implemented as a continuous flexible element rather than a plurality of shutter elements.

In Figs. 4A and 4B, the actuator arrangement is shown to comprise a plurality of actuator elements which each actuate the movement of a different portion of the second coil array 420. However, in alternative embodiments of the coil array 400, the actuator arrangement 430 may comprise only a single actuator.

Fig. 4A shows the second coil array 420 in a deployed position in which the first coil array is stored within the solid base part of the first coil array 410. Thus, in this position the lightweight second coil array is protected from damage during transport and storage.

Fig. 4B shows the second coil array 420 in a deployed position in which the flexible coil array extends to flex around the anatomical feature 150 which is being supported by the first coil array 410. This positioning of the second coil array 420 permits accurate MRI of the anatomical feature 450 to be performed using both the first and second coil arrays.

Fig. 4C shows a side view of the coil arrangement 400 when the second coil array 420 is in the deployed position. In this exemplary embodiment, the first coil array 410 comprises a first segment 413 and a second segment 414 and the second coil array 420 comprises a first segment 423 and a second segment 424.

As depicted in Fig. 4C, in the coil arrangement 400, movement of the second coil array from the undeployed position to the deployed position further comprises movement of the second segment 424 of the second coil array relative to the first segment 423 in an axial direction indicated by the arrow 460. At the same time, the actuator arrangement 430 may be further configured to move the second segment 414 of the first coil array 410 relative to the first segment 413 in the same axial direction 460. This particular arrangement allows the coil to have a smaller footprint for transport and allows the system to adapt to different sizes and shapes of the anatomical feature 450 being imaged.

When the coil arrangement is in the undeployed position the second segment 414 of the first coil array and the second segment 424 of the second coil array may be positioned completely within the first segment 413 of the first coil array 410. Alternatively, in the deployed position, the second segment 414 of the first coil array and the second segment 424 of the second coil array may extend slightly beyond the extent of the first segment 413 of the first coil array. Whilst in Fig. 4C the first and second coil array are each shown to have first and second segments, it will be understood that each of the first and second coil array may have more than two segments, for example each of the first and second coil arrays may have three segments, or five segments. In this way, successive segments can be deployed in an axial direction when the second coil array moves from the undeployed position to the deployed position to increase the axial extend of the coil arrangement in the deployed position.

It will be understood that the principle depicted in Fig. 4C may also be applied to a coil arrangement of the present invention in which the second coil array comprises a plurality of shutter elements (for example, the coil arrangement 100 or the coil arrangement 200). As such, in some embodiments, each of the plurality of shutter elements of a second coil array may comprise a first segment and a second segment, and movement of the second coil array between an undeployed position and a deployed position may comprise movement of the second segment of each of the plurality of shutter elements, relative to the first segment of the shutter element in an axial direction.

Whilst in Figs. 4A-4C the second coil array 420 is shown to comprise a continuous flexible element that moves in one direction from the undeployed position to the deployed position, in an alternative embodiment the second coil array 420 may comprise two portions that each move in different directions relative to the first coil array, in a similar manner to the second coil array 120 of the coil arrangement 100.

Similarly, other aspects of the coil arrangement 400 may be implemented differently in alternative embodiments. For example, the first coil array 410 need not comprise first and second segments 413 and 414, and the second coil array 420 need not comprise first and second segments 423 and 424. Instead each coil array may comprise only a single segment. As such, movement of the second coil array between the undeployed position and the deployed position may only comprise movement of the second coil array to wrap around the anatomical feature 450 in a longitudinal direction.

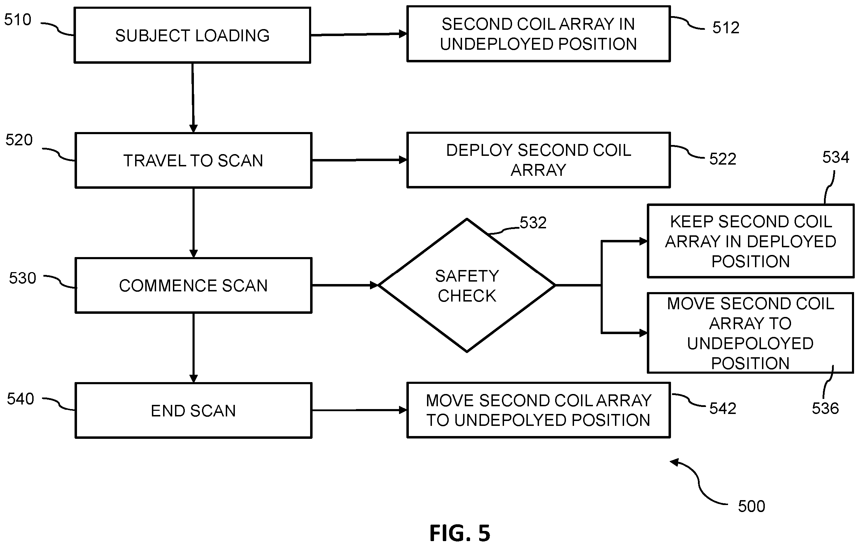

Referring now to Fig. 5, there is depicted a simplified flow diagram of one possible algorithm 500 for controlling a coil arrangement of the present invention. The algorithm 500 is discussed below in the context of controlling the coil arrangement 100, but it may be used in a similar way to control any coil arrangement of the present invention, for example, the coil arrangement 200 or the coil arrangement 400.

As described above, the controller 140 of the coil arrangement 100 may be configured in various ways to respond to the environment around the coil arrangement 100. The algorithm 500 shows just one possible way in which the actuator may be controlled at various stages of an MRI procedure. The algorithm 500 may be implemented in software or hardware by the controller 140.

In a step 510 of the algorithm 500, the controller may receive an instruction signal describing that the MRI system is in a patient loading state. In other words, a subject is being prepared and positioned ready for imaging. In response to receiving the patient loading signal, the controller 140 controls the actuator arrangement 130 according to step 512 such that the second coil array 120 is in the undeployed position. As described above, this allows the subject to easily position themselves correctly with respect to the first coil without the assistance of the operator.

Once the subject is loaded, the controller 140 receives a second signal in a step 520 that indicates that the subject and coil array are about to be transported to the location of a superconducting magnet for MRI. Upon receipt of this signal, the controller 140 controls the actuator 130 to move the second coil array to the deployed position - as shown in step 522 of the algorithm 500.

Once the subject and coil arrangement 100 have been transported to the MRI system for imaging the controller receives a third signal at a step 530 that indicates that the scan has commenced. Throughout the period of the scan a safety check 532 is continually carried out to check the state of the MRI system and the state of the subject. Signals may therefore be received at the controller 140 indicating the state of the MRI system and/or the state of the subject during the scan. If the received signals indicate that the subject and the MRI system is in a safe and stable state, the controller 140 controls the actuator arrangement 130 according to step 534 such that the second coil array 120 remains in the deployed position. If, however, a signal received at the controller 140 indicates that an error or emergency has occurred the controller will control the actuator 130 to move the second coil array from the deployed position to the undeployed position, in a step 536, such that it is easy for the subject to remove themselves, or be removed from, the confines of the coil arrangement 100.

Once the scan has been completed, in step 540, the controller 140 receives a signal that indicates the scan has ended. The controller is then configured, in response to this signal, in step 542 to control the actuator to move the second coil array to the undeployed position to allow the subject to remove themselves from the scan position.

The signals received in steps 510, 520, 530, 532, and 540 of the algorithm 500 may originate from an input interface provided to the operator of the MRI system. As such, throughout the preparation and imaging of the subject the operator may select options to indicate the stage of imaging and the status of the MRI system and the subject that are then used to inform the actions of the controller 140. In other embodiments, the MRI system and/or the coil arrangement may comprise one or more sensors which detect the status of the subject and the MRI system. For example, a weight sensor or position sensor, may be used to detect when the subject is in position for imaging. Temperature and smoke sensors may be used during the safety check to ensure that there is no overheating or fire. Vital sign sensors (including subject blood pressure, pulse, and breathing rate) can be used to check on the health and discomfort levels of the subject. Thus, in some embodiments the actions of the controller and actuator may be fully automated.

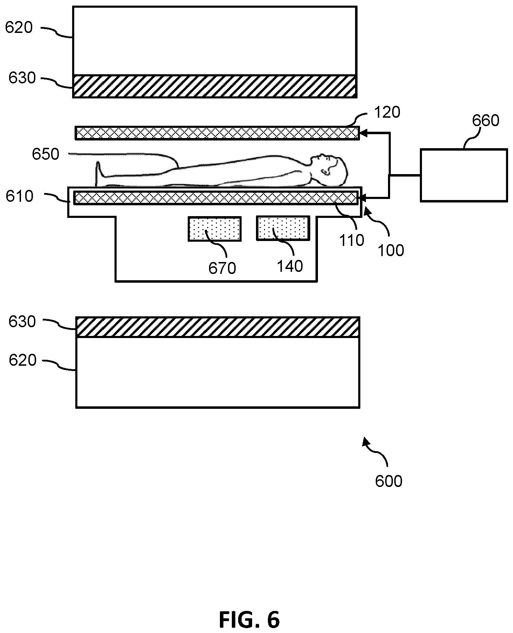

Referring now to Fig. 6, there is depicted a simplified diagram of an MRI system 600 according to another aspect of the proposed invention.

The MRI system 600 is only shown with its most fundamental components, i.e., components which are of relevance for the present invention. In this respect, the MRI system 600 comprises a patient support structure 610 for supporting the position of the position of the subject for imaging by the MRI system, a superconducting magnet 620, a gradient coil 630 within the bore of the super conducting magnet and the coil arrangement 100. It will be understood that other embodiments of the coil arrangement of the present invention, for example the coil arrangement 200 or the coil arrangement 400 may be used in the MRI system 600 instead. In this particular embodiment, the coil arrangement 100 has been adapted for full body imaging of the subject 650, however the coil arrangement may be configured for imaging other anatomical features of the subject.

Fig. 6 shows the coil arrangement 100 when the second coil is in the deployed position and therefore ready for imaging. As described above the coil arrangement 100 is an integrated transmitting and receiving coil. In other embodiments, the coil arrangement 100 may perform only one of these functions and therefore the MRI system may comprise further coil arrays for performing the functions unable to be performed by the coil arrangement 100.

During imaging, the first and second coil arrays (110, 120) emit RF pulses, which are supplied from a RF transmitter 660, and generate a radio frequency magnetic field within the bore of the superconducting magnet 620.

As is well known by one of ordinary skill in the art, by transmitting RF pulses which have an orthogonal polarization to the magnetic field generated by the superconducting magnet 620 and matching the Larmor frequency of the nucleons of interest, the spins of the nucleons can be excited and brought into phase, and a deflection of their net magnetization from the direction of the field of the superconducting magnet 620 is obtained so that a transversal component in relation to the longitudinal component of the net magnetization is generated.

After termination of the RF pulse, the relaxation process of the longitudinal and reversal components of the net magnetization begin until the net magnetization has returned to its equilibrium state. Magnetic resonance signals, which are generated by the precessing magnetization are detected by means of the coil arrangement 100. The received magnetic resonance signals are time-based amplitude signals, which are further Fourier transformed to frequency-based magnetic resonance spectrum signals and further processed for generating a magnetic resonance images. The MRI system 600 therefore facilitates imaging of the anatomical features of the subject.

In this particular embodiment, the MRI system 600 further comprises one or more sensors 670 configured to detect at least one of: the state of the MRI system; and the state of the subject. The one or more sensors 670 are further configured to generate a sensor signal describing a measurement made of the state of the MRI system and/or subject and transmit these to the controller 140. The controller is then configured to control the actuator to move the second coil array between an undeployed position and a deployed position based on the received sensor signal.

A coil arrangement of the present invention may therefore be used within an MRI system for imaging the anatomical features of a subject.

As discussed above, embodiments make use of a controller. The controller can be implemented in numerous ways, with software and/or hardware, to perform the various functions required. A processor is one example of a controller which employs one or more microprocessors that may be programmed using software (e.g., microcode) to perform the required functions. A controller may however be implemented with or without employing a processor, and also may be implemented as a combination of dedicated hardware to perform some functions and a processor (e.g., one or more programmed microprocessors and associated circuitry) to perform other functions.

Examples of controller components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media such as volatile and non-volatile computer memory such as RAM, PROM, EPROM, and EEPROM. The storage media may be encoded with one or more programs that, when executed on one or more processors and/or controllers, perform the required functions. Various storage media may be fixed within a processor or controller or may be transportable, such that the one or more programs stored thereon can be loaded into a processor or controller.

Variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. If a computer program is discussed above, it may be stored/distributed on a suitable medium, such as an optical storage medium or a solid-state medium supplied together with or as part of other hardware, but may also be distributed in other forms, such as via the Internet or other wired or wireless telecommunication systems. If the term "adapted to" is used in the claims or description, it is noted the term "adapted to" is intended to be equivalent to the term "configured to". Any reference signs in the claims should not be construed as limiting the scope.

## Claims

1. A coil arrangement (100) for use in an MRI system, the coil arrangement comprising:
first (110) and second (120) coil arrays each configured, in use, to transmit signals to and/or receive signals from an anatomical feature of a subject that is to be imaged by the MRI system,
wherein the second coil array is configured to be moveable relative to the first coil array between an undeployed position, in which the second coil array permits the anatomical feature of the subject to be positioned relative to the first coil array such that MRI of the anatomical can be performed using the first coil array, and a deployed position, in which the second coil array is positioned such that MRI of the anatomical feature can be performed using both the first and second coil array;
an actuator arrangement (130) configured to move the second coil array between the undeployed position and the deployed position; and
a controller (140) for controlling the actuator arrangement.

2. The coil arrangement of claim **1,** wherein when the second coil array is in the deployed position the first and second coil arrays, in use, extend around the anatomical feature of the subject about a longitudinal axis,
and optionally wherein when the second coil array is in the deployed position, in use, the first and second coil arrays fully encompass the anatomical feature of the subject in a first plane perpendicular to the longitudinal axis.

3. The coil arrangement of any of claims 1 and 2, wherein the second coil array (300) comprises a plurality of shutter elements (310), each of the plurality of shutter elements coupled to an adjacent shutter element of the plurality of shutter elements by a hinge mechanism (320).

4. The coil arrangement of any preceding claim, wherein the second coil array comprises a first portion (121) and a second portion (122), and
wherein movement of the second coil array from the undeployed position to the deployed position comprises movement of the first portion in a first direction and movement of the second portion in a second direction different from the first direction.

5. The coil arrangement of any preceding claim, wherein the coil arrangement further comprises a biasing system configured to bias the second coil array to the undeployed position.

6. The coil arrangement of any preceding claim, wherein the second coil array comprises a flexible arrangement such that the shape of the second coil array can be adjusted when the second coil array moves between the deployed position and the undeployed position.

7. The coil arrangement of any preceding claim wherein the controller is configured to:
receive an instruction signal; and
control the actuator arrangement to move the second coil array between the undeployed position and the deployed position based on the received instruction signal.

8. The coil arrangement of any preceding claim, wherein the controller is configured to:
receive a system status signal describing the status of the MRI system; and
control the actuator arrangement to move the second coil array between the undeployed position and the deployed position based on the received system status.

9. The coil array of claim 8, wherein the system status signal describes at least one of:
a loading state which indicates the subject or imaging phantom is being positioned relative to the MRI system;
a travel state which indicates the MRI system is being transported;
an imaging state which indicates the MRI system is in use for imaging the anatomical feature of the subject;
a therapy state which indicates a clinical therapy is being applied to the subject;
a preparation state which indicates a contrast agent is being applied to the subject; and
an emergency state.

10. The coil array of any preceding claim, wherein the controller is configured to:
receive a subject status signal describing a state of the subject; and
control the actuator arrangement to move the second coil array between the deployed and the undeployed positions based on the received subject status signal.

11. The coil array of claim 10, wherein the subject status signal describes at least one of:
a panic level of the subject;
a motion level of the subject;
a position of the subject;
a level of discomfort of the subject; and
a vital sign measurement of the subject.

12. The coil array of any preceding claim, wherein the controller is configured to:
receive a sensor signal describing a measurement of a sensor of the MRI system; and
control the actuator arrangement to move the second coil array between the deployed and the undeployed positions based on the received sensor signal.

13. The coil array of claim 12, wherein the sensor signal describes at least one of:
a position of the subject;
a presence of smoke;
a temperature;
a detected sound;
a motion of the subject; and
a vital sign of the subject.

14. An MRI system (600) for imaging an anatomical feature of a subject, the MRI system comprising:
a patient support structure (610) for supporting the position of the anatomical feature for imaging by the MRI system;
a superconducting magnet (620);
a gradient coil (630); and
the coil arrangement of any of claims 1-13.

15. The MRI system of claim 14 further comprising one or more sensors (570) for measuring at least one of:
the state of the MRI system; and
the state of the subject.
